# EUROPEAN PATENT SPECIFICATION

(11) **EP 1 981 065 B1**
(45) Date of publication and mention of the grant of the patent: **03.12.2014**
(21) Application number: 06781031.7
(22) Date of filing: 12.07.2006
(51) Int. Cl.: H01L 21/02, C30B 29/06, H01L 27/12

(54) **PROCESS FOR PRODUCING SOI WAFER**
PROZESS ZUM HERSTELLEN EINES SOI-WAFERS
PROCEDE DE PRODUCTION DE TRANCHES SOI

(30) Priority: 27.12.2005 JP 2005374892
(43) Date of publication of application: 15.10.2008
(73) Proprietor: Shin-Etsu Chemical Company, Ltd., Tokyo 100-0004 (JP)
(72) Inventor: ITO, Atsuo, Tokyo 100-0004 (JP); KUBOTA, Yoshihiro, Tokyo 100-0004 (JP); MITANI, Kiyoshi, Annaka-shi, Gunma 379-0196 (JP)
(74) Representative: Pfenning, Meinig & Partner GbR
(86) International application number: PCT/JP2006/313911
(87) International publication number: WO 2007/074552

(56) References cited:
- EP-A- 0 961 312
- EP-A- 1 557 883
- EP-A- 1 598 452
- EP-A- 1 605 510
- WO-A1-2004/083496
- JP-A- 03 091 227
- JP-A- 05 029 183
- JP-A- 07 249 749
- JP-A- 2000 036 583
- JP-A- 2001 244 444
- JP-A- 2001 511 608
- JP-A- 2004 221 198
- ABE T. ET AL.: 'Hariawase SOI Wafer no Kongo no Tenkai' OYO BUTSURI vol. 66, no. 11, 1997, pages 1220 - 1224, XP008082324

## Description

### TECHNICAL FIELD

The present invention relates to a manufacturing method of an SOI wafer and to an SOI wafer. Particularly, the present invention relates to a manufacturing method of an SOI wafer in which an SOI layer is formed on a transparent insulation substrate, and to the SOI wafer. The present application relates to Japanese Patent Applications No. 2004-380587 filed on December 28, 2004 and No. 2005-374892 filed on December 27, 2005, the contents of which are incorporated herein by reference, if applicable.

### BACKGROUND ART

An SOI wafer including an SOI (silicon on insulator) structure in which a silicon single crystal layer is formed on an insulator is suited for fabricating a semiconductor integrated circuit of a high density, and is expected to be applied to optical devices such as "TFT-LCD" (thin film transistor - liquid crystal display).

An SOI wafer in which an SOI layer is formed on a transparent silica substrate is used as such an optical device, for example. In this case, the substrate is a complete insulator, and so does not affect the mobility of a carrier within the SOI layer. Consequently, the mobility of the carrier in the SOI layer will be extremely high, thereby yielding a noticeable effect particularly when driven in high frequency. In a case where a polycrystalline silicon film is formed on the silica substrate using a CVD method or the like, a maximum value of mobility of electrons, which is indicative of speed and color of the LCD display, is about 100 cm²/V·sec for a P-type and 200 cm²/V·sec for an N-type, but higher acceleration can be expected when the SOI layer is used. In addition, in such an SOI wafer, a driving circuit can be formed in an integral manner in the periphery of the TFT region, which enables high density mounting.

In such an SOI wafer for use as an optical device, the thickness of the SOI layer should be as thin as about 0.5µm, for example. Accordingly, the bonding strength between the silica substrate and the SOI layer should be sufficiently strong and firm to endure grinding, polishing for making the SOI layer to be as thin as the level of the stated thickness, and to withstand the thermal and mechanical stresses exercised on the SOI layer during manufacturing of the device. Therefore, it is necessary to enhance the bonding strength through thermal processing at a high temperature.

However, the thermal expansion coefficient differs between a silica substrate and an SOI layer. This occasionally causes stress due to thermal deformation during the thermal processing for bonding, during the cooling processing after the bonding, or during the grinding or polishing processing, thereby causing the silica substrate or the SOI layer to crack, or to break due to flaking. Such a problem is not confined to a case where the insulation transparent substrate is made of silica, and may equally happen when bonding a single crystal silicon wafer to a substrate having a different thermal expansion coefficient.

So as to solve the aforementioned problem, a technology has been disclosed for alleviating the effect of thermal stress occurring in thermal processing, by performing a thermal bonding processing process and a thin film process alternately and step by step, in an SOI wafer manufacturing method adopting a hydrogen ion injection peeling method (e.g. Patent Document No. 1).
Patent Document No. 1: Japanese Patent Application Publication No. HI 1-145438

On the other hand, in a case where a MOSFET (metal oxide semiconductor field effect transistor) is used as the TFT in the SOI layer of the SOI wafer, a leak current (light leak current) is caused by the light from the back surface of the substrate being incident to a channel region of the MOSFET due to the substrate being transparent, thereby degrading the characteristics of the device.

In response to this problem, a technology has been disclosed for preventing the light leak current from arising by forming a light shield layer between the substrate and the SOI layer to block light from the back surface of the substrate that is incident to the light shield layer. (e.g. Patent Document No. 2).
Patent Document No. 2: Japanese Patent Application Publication No.H10-293320

Further, the document EP1605 510 relates to a method of manufacturing an SOI wafer having extremely high electrical reliability. The SOI is formed by implanting oxygen into a silicon wafer and then performing heat-treatment, to form a silicon active layer insulated by the insulator film layer in the wafer, wherein at least a silicon wafer consisting of a P-doped silicon single crystal grown by Czochralski method is occupied by N region and/or defect-free I region.

### DISCLOSURE OF THE INVENTION

### PROBLEMS TO BE SOLVED BY THE INVENTION

Regarding a manufacturing method of an SOI wafer in which an SOI layer is formed on a transparent insulation substrate, the present invention aims to provide a manufacturing method of an SOI wafer, by which thermal deformation, flaking, cracking, or the like attributable to the difference in thermal expansion coefficients between a transparent insulation substrate and an SOI layer is prevented with a simple process, and by which light leak current can be restricted when a semiconductor device is fabricated in the SOI layer.

### MEANS FOR SOLVING THE PROBLEMS

So as to achieve the above objectives, as a first embodiment of the present invention, provided is a manufacturing method for manufacturing an SOI wafer by bonding a single crystal silicon wafer to a transparent insulation substrate, and thereafter making the single crystal silicon wafer to be thinned to form an SOI layer on the transparent insulation substrate, the manufacturing method characterized in performing at least: a step of growing a single crystal silicon whose entire surface is an N region on an outer side of an OSF region, using a Czochralski method, and fabricating a wafer by slicing the grown N region single crystal silicon; a step of forming an ion injection layer within the N region single crystal silicon wafer, by injecting at least one of a hydrogen ion and a rare gas ion from a surface of the N region single crystal silicon wafer; a step of processing the ion injection surface of the N region single crystal silicon wafer and/or a surface of the transparent insulation substrate using plasma and/or ozone; a step of bonding the ion injection surface of the N region single crystal silicon wafer to a surface of the transparent insulation substrate, by bringing them into close contact with each other at room temperature, with the processed surface(s) as bonding surface(s); and a step of forming an SOI layer on the transparent insulation substrate, by mechanically peeling the single crystal silicon wafer by giving an impact to the ion injection layer.

In this manner, the present invention uses a wafer obtained by slicing a single crystal silicon grown by a Czochralski method such that the entire surface thereof is the N region on an outer side of an OSF region, in other words, an N region single crystal silicon in which grown-in defects, such as defects caused by porous defects or interstitial silicon, are almost nonexistent. Furthermore, by injecting an ion from the surface of the N region single crystal wafer and processing the ion injection surface of the N region single crystal silicon wafer and/or the surface of the transparent insulation substrate using plasma and/or ozone, an OH group will be increased and activated on the injection surface of the wafer and/or a surface of the substrate. If the ion injection surface of the N region single crystal silicon wafer and the surface of the transparent insulation substrate, under such a state, are brought into close contact with each other at room temperature to be bonded, with the processed surfaces as the bonding surfaces, the surfaces brought into close contact will be firmly bonded by means of hydrogen bonding, to obtain sufficiently firm bonding even without providing high temperature thermal processing for raising the bonding strength in later stages. In addition, since the bonding surfaces are firmly bonded to each other in the above manner, thereafter a thin SOI layer can be formed on the transparent insulation substrate by mechanically peeling the N region single crystal silicon wafer by giving an impact to the ion injection layer. This means that a thin film can be obtained even without performing thermal processing for peeling. This further indicates that an SOI wafer can be manufactured without causing thermal deformation, flaking, cracking, or the like attributable to the difference in thermal expansion coefficient between the transparent insulation substrate and the single crystal silicon wafer. In addition, since the peeling method involving hydrogen ion injection into the N region single crystal silicon wafer is used, it is possible to manufacture an SOI wafer whose N region SOI layer has a thin film thickness, a favorable film thickness evenness, and excellent crystallization in which grown-in defects are almost nonexistent. Furthermore, since the SOI layer is made of the N region, degradation of the characteristic of the elements caused by the light leak current can be restricted when a semiconductor device is fabricated in the SOI layer.

Hereinafter, in regards to the N region, a relationship between a lift speed and defects of the single crystal silicon grown using the Czochralski method is described.

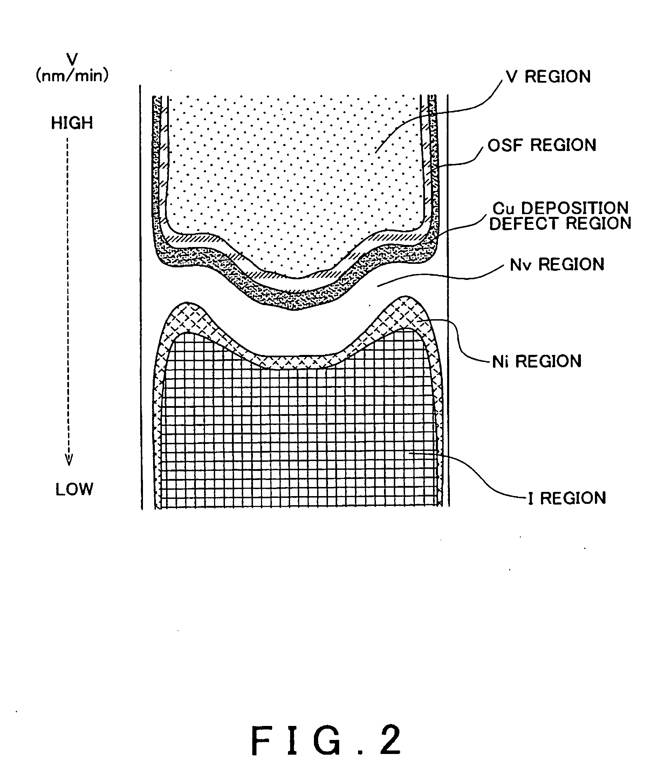

A defect distribution as shown in Fig. 2 is achieved when a growth speed V in a crystal axis direction is changed by a CZ lifting mechanism that uses an in-core structure (hot zone) with a thermal gradient G near a solid-liquid interface in the crystal. In the defect distribution, the vertical axis represents V (mm/min); a V region is a region in which a large amount of porous defects such as FPD, LSTD, and COP exist; an I region is a region in which a large amount of defects caused by interstitial silicon such as LSEPD and LFPD exist; and an N region is a region between the I region and the V region, in which grown-in defects such as defects caused by the porous defects or the interstitial silicon are almost nonexistent. Furthermore, an OSF (oxidation induced stack in fault) region, in which OSF defects are present, exists near the border of the V region. Accordingly, the N region is on an outer side of the OSF region. The N region includes an Nv region that is adjacent to the outer side of the OSF region and an Ni region that is adjacent to the I region. Accordingly, the single crystal silicon, whose entire surface is the N region on the outer side of the OSF region, can be obtained by controlling V/G by adjusting the hot zone setting and the growth speed.

In this case, it is desirable that the single crystal silicon grown in the manner described above not include defects detectable by the Cu deposition method (Claim 2).

When the single crystal silicon grown in the manner described above does not include defects detectable by the Cu deposition method, an SOI layer can be formed having extremely high quality crystallization characteristics, and in which the grown-in defects are further decreased. By doing this, the occurrence of the light leak current can be further restricted.

The Cu deposition method is an evaluation method involving applying a potential to an oxide layer formed on a surface of a wafer in a solution into which Cu ions are dissolved, so that a current flows to portions of the oxide layer that are decayed, which causes the Cu ions to become Cu and be separated. As shown in the defect distribution diagram of Fig. 2, the region in which defects are detectable by the Cu deposition method is a portion of the Nv region adjacent to the OSF region (sometimes referred to hereinafter as the "Cu deposition defect region"). In the Cu deposition defect region, extremely small defects such as COP are known to exist in the portions of the oxide layer that decay easily.

Between the step of bonding and the step of forming an SOI layer, it is preferable to perform a step of raising a bonding strength by performing thermal processing to the bonded wafer under a temperature of 100-300 degrees centigrade (Claim 3).

As in the above manner, if the single crystal silicon wafer and the transparent insulation substrate bonded to each other are subjected to the mechanical peeling step for giving an impact to the ion injection layer, after raising the bonding strength by performing thermal processing of a low temperature of 100-300 degrees centigrade which does not cause thermal deformation, it is possible to manufacture an SOI wafer by more assuredly preventing the generation of flaking, cracking, or the like of the bonding surfaces attributable to the mechanical stress.

It is preferable that mirror polishing is provided to a surface of the SOI layer of the SOI wafer obtained in the step of forming an SOI layer (Claim 4).

In this way, by providing mirror polishing to a surface of the SOI layer of the SOI wafer obtained in the step of forming an SOI layer, it is possible to remove surface roughness of the SOI layer caused in the SOI layer forming process or to remove the crystal defects or the like caused in the ion injection process, thereby enabling manufacturing of an SOI wafer having an SOI layer whose surface is mirror polished and smooth.

It is preferable that the transparent insulation substrate is one of a silica substrate, a sapphire (alumina) substrate, and a glass substrate (Claim 5).

As in the above way, if the transparent insulation substrate is one of a silica substrate, a sapphire (alumina) substrate, and a glass substrate, it is possible to manufacture an SOI wafer suitable for fabricating an optical device, since these substrates have a favorable optical characteristic. Here, examples of the glass substrate include highly clear opaque glass, borosilicate glass, alkali-free borosilicate glass, aluminoborosilicate glass, and crystallized glass, in addition to soda-lime glass in common use. When using a glass substrate that includes alkali metal (e.g. soda-lime glass), it is desirable that a surface of the glass substrate be provided with a diffusion protective film made of spin-on glass, for preventing diffusion of alkali metal from the surface.

Further, it is preferable that an ion injection dose used in the step of forming an ion injection layer be greater than 8 × 10¹⁶/cm² (Claim 6).

As in the above way, by setting the ion injection dose to be greater than 8×10¹⁶/cm² in forming the ion injection layer, the mechanical peeling becomes easy.

In addition, the present invention provides an SOI wafer manufactured according to any of the manufacturing methods recited above (Claim 7).

As in the above way, an SOI wafer manufactured according to any of the above-described manufacturing methods has suffered from any thermal deformation, flaking, cracking, or the like during manufacturing, and also has a thinner film thickness and a more favorable film thickness evenness, excellent N region crystallization, and has an SOI layer on a transparent insulation substrate having high carrier mobility, which is useful for manufacturing various devices. Furthermore, when a MOSFET or the like is fabricated in the SOI layer, the SOI wafer restricts characteristic decay of elements caused by a light leak current.

The present invention provides an SOI wafer including an SOI layer having a thickness less than or equal to 0.5 µm formed on a transparent insulation substrate, in which an entire surface of the SOI layer is an N region on an outer side of an OSF region, and the carrier mobility of the SOI layer is greater than or equal to 250 cm²/V·sec for an N-type and greater than or equal to 150 cm²/V·sec for a P-type (Claim 8).

Therefore, when the SOI wafer includes the SOI layer having a thickness less than or equal to 0.5 µm formed on the transparent insulation substrate, an entire surface of the SOI layer is the N region on an outer side of the OSF region, and the carrier mobility of the SOI layer is greater than or equal to 250 cm²/V·sec for an N-type and greater than or equal to 150 cm²/V·sec for a P-type, the SOI wafer has a thinness suitable for use in an optical device, has excellent N region crystallization, and has the SOI layer on the transparent insulation substrate with high carrier mobility. Furthermore, when a MOSFET or the like is fabricated in the SOI layer, the SOI wafer can restrict the decay of characteristics of an element by the light leak current.

In this case, it is desirable that the SOI layer not include a defect region detectable by the Cu deposition method (Claim 9).

When the SOI layer does not include a defect region detectable by the Cu deposition method, the light leak current can be further restricted.

### EFFECT OF THE INVENTION

By adopting the manufacturing method of an SOI wafer according to the present invention, the surfaces to be bonded are processed with plasma and/or ozone prior to bonding of the N region single crystal silicon wafer and the transparent insulation substrate, which increase and activates the OH group on the surfaces. If the N region single crystal silicon wafer and the transparent insulation substrate, under such a state, are brought into close contact with each other at room temperature to be bonded, the surfaces brought into close contact will experience sufficiently firm bonding even without providing high temperature thermal processing for raising the bonding strength in later stages. In addition, since the bonding surfaces are firmly bonded to each other in the above manner, thereafter a thin SOI layer can be formed on the transparent insulation substrate by mechanically peeling the N region single crystal silicon wafer by giving an impact to the ion injection layer. This means that a thin film can be obtained even without performing thermal processing for peeling. This further indicates that an SOI wafer can be manufactured without causing thermal deformation, flaking, cracking, or the like attributable to the difference in thermal expansion coefficient between the transparent insulation substrate and the single crystal silicon. Furthermore, because the hydrogen ion injection peeling method is used for the N region single crystal silicon, an SOI wafer can be manufactured that has a thinner film thickness, a more favorable evenness in film thickness, and an N region SOI layer with excellent crystallization in which grown-in defects are almost nonexistent. When a semiconductor device is fabricated in the SOI layer, decay of characteristics of an element by the light leak current can be restricted because the SOI layer is made up of the N region.

In addition, the SOI wafer according to the present invention is an SOI wafer that does not suffer from thermal deformation, flaking, cracking, or the like during manufacturing, has a thinner film thickness, a more favorable evenness in film thickness, excellent N region crystallization, and an SOI layer on a transparent insulation substrate having high carrier mobility, which is useful for manufacturing various devices. Furthermore, when a MOSFET or the like is fabricated in the SOI layer, the SOI wafer can restrict the decay of characteristics of an element by the light leak current.

The SOI wafer of the present invention includes a sufficiently thin (less than or equal to 0.5 µm) SOI layer that does not suffer from heat deformation, flaking, cracking, and the like, has high carrier mobility that is greater than or equal to 250 cm²/V·sec for an N-type and greater than or equal to 150 cm²/V·sec for a P-type, and can be used in the manufacturing of a TFT-LCD having excellent display speed and color. Furthermore, because the SOI layer is made up of the N region, the SOI wafer can restrict the light leak current when a MOSFET is fabricated in the SOI layer.

### BRIEF DESCRIPTION OF THE DRAWINGS

Fig. 1 is a process diagram showing one example of a manufacturing method of an SOI wafer, according to the present invention.
Fig. 2 is a schematic diagram showing a defect area of a single crystal silicon grown by the CZ method.

### BEST MODE FOR CARRYING OUT THE INVENTION

As described above, technologies have been disclosed whereby, in a method for manufacturing an SOI wafer in which an SOI layer is formed on a transparent insulation substrate, heat deformation, flaking, cracking, and the like caused by a difference in thermal expansion coefficients between the SOI layer and the transparent insulation substrate and, in a method for manufacturing the SOI wafer using a hydrogen ion injection peeling method, the effect of thermal stress occurring in thermal processing is alleviated by performing a thermal bonding processing process and a thin film process alternately and step by step.

However, in order to enhance production of SOI wafer, a technology that solves the aforementioned problems more quickly and with fewer steps is desired.

In view of this, the inventors of the present invention have conceived to enhance the bonding strength without performing the thermal processing by preprocessing the surfaces to be bonded using plasma and/or ozone processing, and to perform peeling mechanically instead of thermal processing, thereby achieving the SOI layer with a thickness less than or equal to 0.5 µm.

In a case where a MOSFET is conventionally fabricated in the SOI layer of the SOI wafer, a light leak current is caused by light from the back surface of the substrate being incident to a channel region of the MOSFET due to the substrate being transparent, thereby decaying the characteristics of the device.

In response to this problem, the inventors of the present invention discovered a technology for controlling the light leak current by using an SOI layer whose entire surface is made up of an N region on an outer side of an OSF region. Although the reason why the light leak current can be controlled by using the SOI layer made up of the N region is unclear, it was thought that a grown-in defect of the SOI layer, particularly light scattering caused by a COP with a normal size of 30∼130 nm, might be related to the generation of the light leak current.

When a light shield film is disposed between the substrate and the SOI layer, as in Patent Document No. 2, the light directly incident to the channel region of the MOSFET is blocked. However, it is thought that the light leak current might also be caused by stray light incident to the source and drain regions, which are present at both ends of the MOSFET and whose surface areas are large, being scattered by the COP to be incident to the channel region of the MOSFET. Because the COP is barely present in the source and drain regions fabricated in the SOI layer made up of the N region, the scattering of visible light with a wavelength greater than or equal to 400 nm caused by the COP does not occur, and therefore it is thought that the light incident to the channel region of the MOSFET, which is caused by the scattering, should decrease.

Hereinafter, some aspects of the present invention are described by way of embodiments. The present invention will not be limited to the following embodiments.

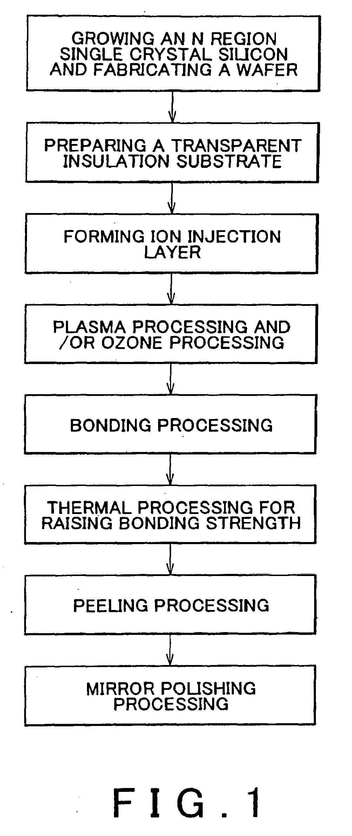

Fig. 1 is a process diagram showing one example of a manufacturing method of an SOI wafer, according to the present invention.

First, a single crystal silicon, whose entire surface is an N region on an outer side of an OSF region, is grown using a CZ method, and a wafer is created by slicing the single crystal silicon (process A).

As shown in the defect distribution chart of Fig. 2, the single crystal silicon whose entire surface is the N region may be grown by regulating a growth speed to be less than or equal to the growth speed at the boundary at which the OSF region generated in a ring shape decreases when the growth speed (lift speed) of the single crystal silicon being lifted by the CZ method gradually decreases from a high speed to a low speed, and to be greater than or equal to the growth speed at the boundary defined by the I region when the growth speed further decreases.

After the single crystal silicon, whose entire surface is the N region, is grown in the manner described above and sliced by a conventional cutting apparatus such as an inner circumference blade slicer or a wire saw, the N region silicon single crystal wafer is fabricated by common processes such as surfacing, wrapping, etching, and polishing.

The single crystal silicon wafer is not particularly limited as long as it is N region, and may have, for example, a diameter of 100-300 mm, a conductivity type of P-type or N-type, and a resistivity of about 10 Ω•cm.

It is desirable that the single crystal silicon grown at this time not include a defect region detectable by a Cu deposition method. To achieve this, the regulated growth speed should be less than or equal to the growth speed of the boundary at which the Cu deposition defect region, which remains after the OSF region decreases, begins to decrease.

Next, a transparent insulation substrate is prepared (process B).

The transparent insulation substrate is also not particularly limited. However if any of a silica substrate, a sapphire (alumina) substrate, and a glass substrate, all of them having a favorable optical characteristic, is used as a transparent insulation substrate, it is possible to manufacture an SOI wafer suitable for fabricating an optical device.

Next, at least one of a hydrogen ion and a rare gas ion is injected from a surface of the N region single crystal silicon wafer, to form an ion injection layer in the wafer (process C).

For example, at least one of a hydrogen ion and a rare gas ion in a predetermined dose is injected from the surface of the N region single crystal silicon wafer, with an injection energy capable of forming an ion injection layer at the depth corresponding to a predetermined SOI layer thickness (e.g. the depth less than or equal to 0.5 µm), while keeping the temperature of the single crystal silicon wafer at 250-450 degrees centigrade. An exemplary condition may be the injection energy of 20-100 keV and the injection dose of 1×10¹⁶ - 1×10¹⁷/cm². Here, so as to facilitate the peeling at the ion injection layer, the ion injection dose should preferably be greater than or equal to 8×10¹⁶/cm². In addition, if the ion injection is performed through an insulation film such as a thin silicon oxide layer formed in advance on a surface of the single crystal silicon wafer, an advantage of restraining channeling of the injected ion will be obtained.

Next, the ion injection surface of this N region single crystal silicon wafer and/or the surface of the transparent insulation substrate is/are processed with plasma and/or ozone (process C).

In adopting plasma processing, an N region single crystal silicon wafer and/or a transparent insulation substrate, to which cleansing such as RCA cleansing has been performed, are/is placed in a vacuum chamber, and a gas for plasma processing (hereinafter simply "plasma gas") is introduced. Then the N region single crystal silicon wafer and/or the transparent insulation substrate are/is subjected to high frequency plasma of about 100 W for about 5-10 seconds, to perform plasma processing to the surface thereof. In processing an N region single crystal silicon wafer, for oxidizing the surface thereof, the plasma gas may be plasma of an oxygen gas. For not oxidizing the surface of an N region single crystal silicon wafer, the plasma gas may be a hydrogen gas, an argon gas, a mixture gas of them, or a mixture gas of a hydrogen gas and a helium gas. Any gas is usable for processing of a transparent insulation substrate.

In adopting ozone processing, an N region single crystal silicon wafer and/or a transparent insulation substrate, to which cleansing such as RCA cleansing has been performed, are/is placed in a chamber to which atmospheric air is introduced, and a plasma gas such as a nitrogen gas, an argon gas, or the like is introduced. Then the surfaces are treated with ozone processing by generating high frequency plasma to convert the oxygen in the atmospheric air into ozone. Here, it is possible to perform any one of plasma processing and ozone processing, or it is also possible to perform both of plasma processing and ozone processing.

By processing with plasma and/or ozone, the organic substances on the surface of the N region single crystal silicon wafer and/or the transparent insulation substrate are oxidized to be removed, and instead the OH group on the surface is increased and activated. The surface to be processed may be a bonding surface. For an N region single crystal silicon wafer, the surface to be processed is an ion injection surface. The processing is desirably performed to both of an N region single crystal silicon wafer and a transparent insulation substrate. However the processing may be performed to only one of the N region single crystal silicon wafer and the transparent insulation substrate.

Then, the ion injection surface of the N region single crystal silicon wafer and the surface of the transparent insulation substrate, to which plasma processing and/or ozone processing are/is provided, are brought into close contact with each other at room temperature to be bonded, with the ion injection surface and the surface as the bonding surfaces (process E).

In the process D, at least one of the ion injection surface of the N region single crystal silicon wafer and the surface of the transparent insulation substrate is processed by plasma processing and/or ozone processing. Consequently, the respective surfaces of the N region single crystal silicon wafer and of the transparent insulation substrate are able to be bonded to each other firmly, with a strength that can endure the mechanical peeling in the later processes, by simply bringing them into close contact with each other, under a reduced pressure or a normal pressure, and at a temperature of about a general room temperature, for example. This means that thermal bonding processing of greater than or equal to 1200 degrees centigrade is not necessary, and so it is preferable since there is no possibility of causing thermal deformation, flaking, cracking, or the like attributable to the difference in thermal expansion coefficient, which is a problem inherent in heating processes.

After this, the bonded wafer may be subjected to thermal processing of a low temperature of 100-300 degrees centigrade, for enhancing the bonding strength (process F).

For example, when the transparent insulation substrate is made of silica, the thermal expansion coefficient is smaller than that of silicon (i.e. Si: 2.33×10⁻⁶, and silica: 0.6×10⁻⁶). Therefore if the silica transparent insulation substrate is heated after being bonded to the silicon wafer having about the same thickness, the silicon wafer will break when exceeding 300 degrees centigrade. Thermal processing of a relatively low temperature as in this process E is desirable since it does not have a possibility of causing thermal deformation, flaking, cracking, or the like attributable to the difference in thermal expansion coefficients. Note that in adopting a thermal processing furnace (i.e. a batch processing type), a sufficient advantage is obtained if the thermal processing time is about 0.5-24 hours.

Next, an N region single crystal silicon wafer is mechanically peeled by giving an impact to the ion injection layer, to form an SOI layer on the transparent insulation substrate (process G).

In the hydrogen ion injection peeling method, thermal processing is performed to the bonded wafer in an inert gas atmosphere of about 500 degrees centigrade, to perform thermal peeling by means of a rearrangement effect of crystal and an aggregating effect of air bubbles of injected hydrogen. In contrast, the present invention performs mechanical peeling by giving an impact to an ion injection layer, and so there is no possibility of causing thermal deformation, flaking, cracking, or the like that would happen due to heating.

For giving an impact to the ion injection layer, a jet may be used to blow a fluid such as gas, liquid, or the like continuously or discontinuously from the side surface of the bonded wafer, for example. However, another method may be adopted as long as the method causes mechanical peeling by impact.

In the above way, an SOI wafer in which an SOI layer is formed on a transparent insulation substrate is obtained in the peeling process. It is preferable to provide mirror polishing to a surface of the SOI layer of the SOI wafer obtained in this way (process H).

This mirror polishing enables removal of surface roughness caused in the peeling process (so-called "haze"), and removal of the crystal defects caused in the vicinity of the SOI layer surface due to the ion injection. An example of this mirror polishing is "touch polish" that removes an extremely small thickness of 5-400 nm.

The SOI wafer produced by the processes of A-H has not experienced any thermal deformation, flaking, cracking, or the like, during manufacturing, and also has a thin film thickness, a favorable film thickness evenness, excellent crystallization, and an SOI layer on a transparent insulation substrate having high carrier mobility, which is useful for manufacturing various devices. Furthermore, such an SOI wafer is particularly suited for fabrication of an optical device such as a TFT-LCD, due to having an SOI layer on the transparent insulation substrate.

In addition, because the entire surface of the SOI layer is the N region and because the SOI layer desirably does not include the Cu deposition defect region, the light leak current can be restricted even when a MOSFET is used.

The SOI wafer described above can include, on the transparent insulation substrate, the SOI layer that has a thickness of 0.5 µm or less and that does not suffer from thermal deformation, flaking, cracking, or the like. The SOI layer, whose entire surface is the N region on the outer side of the OSF region, has a carry mobility greater than or equal to 250 cm²/V·sec for an N-type and greater than or equal to 150 cm²/V·sec for a P-type. Accordingly, in comparison to the polycrystalline silicon whose maximum value for electron mobility is about 200 cm²/V·sec for an N-type and 100 cm²/V·sec for a P-type, the SOI wafer has higher carrier mobility and is suitable for use in a TFT-LCD having a display with excellent speed and color. Furthermore, because the SOI layer is the N region and desirably does not include the Cu deposition defect region, the SOI wafer can restrict the light leak current when a MOSFET is used.

### (Embodiment Example)

A single crystal silicon wafer, which is fabricated from a silicon single crystal stick whose entire surface is the N region, having a diameter of 200 mm and one surface thereof being subjected to mirror polishing is prepared, as a wafer for forming an SOI layer. A silicon oxide layer of 100 nm is formed on the surface of the single crystal silicon wafer by thermal oxidization. The surface roughness (Ra) of the oxide layer at the surface subjected to mirror polishing (i.e. a surface to be bonded) was 0.2 nm. The measurement was performed to the measurement region of 10 µm×10 µm using an atom force microscope.

As a transparent insulation substrate, a synthetic silica wafer having a diameter of 200 mm and one surface thereof being subjected to mirror polishing is prepared. The surface roughness (Ra) of the transparent insulation substrate at the surface subjected to mirror polishing (i.e. a surface to be bonded) was 0.19 nm. The apparatus and the method of measuring have the same condition as the oxide layer of the single crystal silicon wafer.

A hydrogen ion is selected as the ion to be injected to a single crystal silicon wafer through the silicon oxide layer of 100 nm, and the ion is injected under a condition of an injection energy of 35 keV and an injection dose of 9×10¹⁶/cm². The injection depth of the single crystal silicon layer was 0.3 nm.

Next, the single crystal silicon wafer to which the ion has been injected is placed in a plasma processing apparatus, and air is introduced as a plasma gas. Then the high frequency plasma processing is performed for 5-10 seconds by applying a high frequency of 13.56 MHz under a reduced pressure condition of 2 Torr between parallel plate electrodes having a diameter of 300 mm under a high frequency power of 50 W.

As for a synthetic silica wafer, the wafer is placed in a chamber to which atmospheric air is introduced, and an argon gas is introduced as a plasma gas in a narrow space between electrodes. Then by applying a high frequency between the electrodes to generate plasma, the oxygen in the atmospheric air becomes ozonized by the existence of the atmospheric air between the plasma and the substrate. The surface to be bonded is processed by means of the ozone. The processing time was set to 5-10 seconds.

The wafers to which surface processing was performed in the above manner were brought into close contact at room temperature, to start bonding by strongly pressing one end of both wafers in the thickness direction. Then after 48 hours at room temperature, the bonding surface was observed by human eyes. As a result, the bonding was confirmed to extend throughout the substrate.

So as to confirm the bonding strength, one of the wafers is fixed, and the wafer surface of the other wafer is provided with a stress in the parallel direction, in an attempt to perform displacement in the lateral direction, but the displacement did not occur.

Next, so as to peel the ion injection layer by giving an impact thereto, blades of paper cutting scissors were placed at the side surface of the bonded wafers in a diagonal position, thereby knocking in wedges several times. Accordingly, the peeling was caused at the ion injection layer, thereby obtaining an SOI wafer and a remaining single crystal silicon wafer.

The SOI layer surface (peeling surface) was observed by human eyes. As a result, the surface roughness was confirmed to be rougher than the surface roughness of the attached surfaces (Ra=0.2 nm). Therefore polishing is performed to remove a thickness of 100 nm, thereby obtaining a smooth surface having surface roughness (Ra) less than or equal to 0.2 nm. The inside-surface film thickness evenness of this SOI layer was also measured. As a result, favorable film thickness evenness was confirmed, with the film thickness variation being restrained to being less than or equal to ±10 nm within the wafer surface. Furthermore, the crystallization of the SOI layer was evaluated by a SECCO defect evaluation using a liquid resulting from diluting the SECCO etching liquid according to a predetermined method. The confirmed defect density was 2×10³ - 6×10³/cm² which is a favorable value.

The above-described embodiments do not limit the invention. The above-described embodiments are only illustrative, and includes a configuration substantially the same as the technical concept recited in the claims of the invention. Any configuration that has the same effects or advantages is intended to be included in the technical concept of the present invention.

For example, the SOI layer of the SOI wafer already subjected to the processes A-G is already sufficiently thinned. Therefore the high temperature thermal processing (at the temperature in the range between greater than or equal to 500 degrees centigrade, and less than the melting point of silicon) for further raising the bonding strength may be optionally performed depending on purposes.

## Claims

1. A manufacturing method for manufacturing an SOI wafer by bonding a single crystal silicon wafer to an insulation substrate being one of silica, sapphire (alumina) and glass, and thereafter making the single crystal silicon wafer to be thinned to form an SOI layer on the insulation substrate, wherein the manufacturing method comprises at least:
a step of growing a single crystal silicon whose entire surface is an N region on an outer side of an OSF region, using a Czochralski method, and fabricating a wafer by slicing the grown N region single crystal silicon;
a step of forming an ion injection layer within the N region single crystal silicon wafer, by injecting at least one of a hydrogen ion and a rare gas ion from a surface of the N region single crystal silicon wafer with an ion injection dose greater than 8 × 10¹⁶/cm² and not more than 1 × 10¹⁷/cm²;
a step of processing the ion injection surface of the N region single crystal silicon wafer and/or a surface of the insulation substrate using plasma and/or ozone;
a step of bonding the ion injection surface of the N region single crystal silicon wafer to a surface of the insulation substrate, by bringing them into close contact with each other at room temperature, with the processed surface(s) as bonding surface(s);
a step of raising a bonding strength by performing thermal processing to the bonded wafer under a temperature of 100-300 degrees centigrade;
a step of forming an SOI layer on the insulation substrate, by mechanically peeling the single crystal silicon wafer by giving an impact to the ion injection layer.

2. The manufacturing method as set forth in Claim 1, wherein :
the grown single crystal silicon does not include a defect region detectable by a Cu deposition method.

3. The manufacturing method as set forth in any one of Claims 1 or 2, wherein :
mirror polishing is provided to a surface of the SOI layer of the SOI wafer obtained in the step of forming an SOI layer.

## Patentansprüche

1. Herstellungsverfahren zum Herstellen eines SOI-Wafers durch Bonden eines Einkristall-Siliziumwafers auf ein Isolationssubstrat, das eines aus Quarzglas, Saphir (Tonerde) und Glas ist, und danach Dünnermachen des Einkristall-Siliziumwafers, um eine SOI-Schicht auf dem Isolationssubstrat zu bilden, wobei das Herstellungsverfahren zumindest aufweist:
einen Schritt des Aufwachsens eines Einkristallsiliziums, dessen gesamte Oberfläche ein N-Bereich auf einer äußeren Seite eines OSF-Bereichs ist, des Anwendens eines Czochralski-Verfahrens und des Herstellens eines Wafers durch Schneiden des aufgewachsenen N-Bereichs aus Einkristallsilizium;
einen Schritt des Bildens einer Ioneninjektionsschicht innerhalb des N-Bereichs des Einkristall-Siliziumwafers, durch Injizieren von zumindest einem von einem Wasserstoffion und einem Edelgasion von einer Oberfläche des N-Bereichs des Einkristall-Siliziumwafers aus mit einer Ioneninjektionsdosis, die größer als 8 x 10¹⁶/cm² und nicht mehr als 1 x 10¹⁷/cm² ist;
einen Schritt des Bearbeitens der Ioneninjektions-Oberfläche des N-Bereichs des Einkristall-Siliziumwafers und/oder einer Oberfläche des Isolationssubstrats unter Verwendung von Plasma und/oder Ozon;
einen Schritt des Bondens der loneninjektions-Oberfläche des N-Bereichs des Einkristall-Siliziumwafers an eine Oberfläche des Isolationssubstrats, indem sie bei Raumtemperatur in engen Kontakt miteinander gebracht werden, mit der/den bearbeiteten Oberfläche(n) als Bonding-Oberfläche(n);
einen Schritt des Erhöhens einer Bondingfestigkeit durch Durchführen einer thermischen Behandlung des gebondeten Wafers bei einer Temperatur von 100 - 300 Grad Celsius;
einen Schritt des Bildens einer SOI-Schicht auf dem Isolationssubstrat durch mechanisches Abschälen des Einkristall-Siliziumwafers, indem ein Stoß auf die Ioneninjektionsschicht ausgeübt wird.

2. Herstellungsverfahren nach Anspruch 1, bei dem das aufgewachsene Einkristallsilizium keinen Defektbereich enthält, der durch ein Cu-Abscheidungsverfahren erfassbar ist.

3. Herstellungsverfahren nach einem der Ansprüche 1 oder 2, bei dem ein Hochglanzpolieren einer Oberfläche der SOI-Schicht auf dem SOI-Wafer, die in dem Schritt des Bildens einer SOI-Schicht erhalten wurde, vorgesehen ist.

## Revendications

1. Procédé de fabrication destiné à fabriquer une tranche SOI en liant une tranche de silicium monocristallin à un substrat isolant dont l'un est en silice, en saphir (de l'alumine) et en verre, et en amincissant ensuite la tranche de silicium monocristallin pour former une couche SOI sur le substrat isolant, dans lequel le procédé de fabrication comprend au moins :
une étape de croissance d'un silicium monocristallin dont la totalité de la surface est une région N sur une face externe d'une région OSF, au moyen d'un procédé Czochralski et de fabrication d'une tranche par découpage en tranches du silicium monocristallin de la région N que l'on a fait croître ;
une étape de formation d'une couche d'injection d'ions à l'intérieur de la tranche de silicium monocristallin de région N, par injection d'au moins l'un d'un ion d'hydrogène et d'un ion de gaz rare à partir d'une surface de la tranche de silicium monocristallin de région N avec une dose d'injection d'ions supérieure à 8 x 10¹⁶/cm² et ne dépassant pas 1 x 10¹⁷/cm² ;
une étape de traitement de la surface d'injection d'ions de la tranche de silicium monocristallin de région N et/ou d'une surface du substrat isolant au moyen de plasma et/ou d'ozone ;
une étape de liaison de la surface d'injection d'ions de la tranche de silicium monocristallin de région N à une surface du substrat isolant, en les mettant en contact immédiat l'une avec l'autre à température ambiante, la(les) surface(s) étant traitée(s) comme des surface(s) de liaison ;
une étape d'augmentation d'une force de liaison en opérant un traitement thermique sur la tranche liée à une température de 100 à 300 degrés centigrades;
une étape de formation d'une couche SOI sur le substrat isolant, par pelage mécanique de la tranche de silicium monocristallin en soumettant à un impact la couche d'injection d'ions.

2. Procédé de fabrication selon la revendication 1, dans lequel
le silicium monocristallin que l'on a fait croître ne comporte pas de région défectueuse détectable par un procédé de déposition de Cu.

3. Procédé de fabrication selon l'une quelconque des revendications 1 ou 2, dans lequel
un polissage miroir est prévu sur une surface de la couche SOI de la tranche SOI obtenue dans l'étape de formation d'une couche SOI.
